# EUROPEAN PATENT APPLICATION

(11) **EP 4 727 276 A1**
(43) Date of publication of application: **15.04.2026**
(21) Application number: 25191139.2
(22) Date of filing: 22.07.2025
(51) Int. Cl.: H05K 7/20

(54) **CABINET HEAT EXCHANGER**

(30) Priority: 26.07.2024 US 202463676123 P
(71) Applicant: Vertiv Corporation, Westerville, OH 43082 (US)
(72) Inventor: SPIEGEL, Phillip Wayne, Westerville, 43082 (US)
(74) Representative: Bryn-Jacobsen, Caelia

(57) **Abstract**

A system can include a computer equipment cabinet for containing one or more computing units and a cabinet heat exchanger. Each computing unit can include at least one unit heat exchanger. The cabinet heat exchanger can receive a first cooling fluid from each of the unit heat exchangers and transfer heat from the first cooling fluid to a second cooling fluid. The cabinet heat exchanger can receive the first cooling fluid from each of the plurality of computing units through a distinct inlet port. The cabinet heat exchanger can include an outer tube and a plurality of inner tubes. Each inner tube can be disposed within the outer tube. The inner tubes can physically isolate the first cooling fluid from the second cooling fluid.

## Description

### CROSS REFERENCE TO RELATED APPLICATIONS

This application claims the benefit of U.S. Provisional Patent Application No. 63/676,123 filed July 26, 2024.

### TECHNICAL FIELD

The present disclosure relates generally to cooling systems for data centers and more specifically relates to heat exchangers used in cooling systems for data centers.

### BACKGROUND

With artificial intelligence (Al) becoming more popular, the information technology (IT) loads in data centers are on the rise, making every inch of real estate more important and valuable. Current cooling systems typically rely on dedicated cooling cabinets housing heat exchangers and pumps for multiple computing equipment cabinets or racks. These dedicated cooling cabinets can occupy significant portions of the space in data centers. Furthermore, the failure of any component in such dedicated cooling cabinets can lead to the shutdown of several, if not all, computing equipment cabinets in the data center.

### SUMMARY

Applicant has created new and useful devices, systems and methods for heat exchangers used in cooling systems for data centers. By locating a heat exchanger in each computer equipment cabinet, such as in existing dead space, the use of valuable real estate can be maximized and system redundancy can be achieved. Embodiments of the disclosure can provide several unique advantages. For example, by locating a heat exchanger in each computer equipment cabinet, the overall amount of refrigerant required can be reduced and relatively long plumbing lines can be eliminated.

In at least one embodiment, a system according to the disclosure can include a computer equipment cabinet for containing a plurality of computing units and/or a cabinet heat exchanger disposed at least partially in the cabinet. In at least one embodiment, each computing unit can include at least one unit heat exchanger, such as a cold plate thermally coupled to a processor. In at least one embodiment, the cabinet heat exchanger can receive a first cooling fluid from each of the unit heat exchangers and/or transfer heat from the first cooling fluid to a second cooling fluid. In at least one embodiment, the cabinet heat exchanger can have an outlet port fluidically coupled to a pump for circulating the first cooling fluid through the unit heat exchangers and the cabinet heat exchanger. In at least one embodiment, the cabinet heat exchanger can be fluidically coupled to an external cooling circuit for removing heat from the second cooling fluid.

In at least one embodiment, the cabinet heat exchanger can receive the first cooling fluid from each of the plurality of computing units through a distinct inlet port. For example, the cabinet heat exchanger can have a plurality of inlet ports to receive the first cooling fluid from the unit heat exchangers, a distinct inlet port for each of the plurality of computing units, a distinct inlet port for each of the unit heat exchangers, or any combination thereof.

In at least one embodiment, the cabinet heat exchanger can include an outer tube and/or a plurality of inner tubes. In at least one embodiment, each inner tube can be disposed at least partially within and/or parallel to the outer tube. In at least one embodiment, the inner tubes can physically isolate the first cooling fluid from the second cooling fluid. In at least one embodiment, the first cooling fluid can flow within the inner tubes and the second cooling fluid can flow within the outer tube and outside of the inner tubes. In at least one embodiment, the second cooling fluid can flow within the inner tubes and the first cooling fluid can flow within the outer tube and outside of the inner tubes.

In at least one embodiment, the cabinet heat exchanger can be vertically aligned. In at least one embodiment, the cabinet heat exchanger can have a top port and/or a bottom port through which the second cooling fluid flows. In at least one embodiment, the cabinet heat exchanger can have a plurality of inlet ports spaced between the top port and the bottom port. In at least one embodiment, each inlet port can receive the first cooling fluid from a different one of the unit heat exchangers. In at least one embodiment, the cabinet heat exchanger can have an outlet port, such as adjacent to the bottom port, which can be fluidically coupled to a pump for circulating the first cooling fluid through the unit heat exchangers and the cabinet heat exchanger. In at least one embodiment, the cabinet heat exchanger can have an expansion port, such as adjacent to the top port, which can be fluidically coupled to a receiver for the first cooling fluid.

In at least one embodiment, the cabinet heat exchanger can have a plurality of inlet ports. In at least one embodiment, each inlet port can receive the first cooling fluid from a different one of the unit heat exchangers. In at least one embodiment, each inlet port can be fluidically coupled to an interior of the outer tube and fluidically isolated from an interior of the inner tubes. In at least one embodiment, each inlet port can be fluidically coupled to an interior of at least one of the inner tubes.

In at least one embodiment, a cabinet heat exchanger according to the disclosure can be disposed at least partially within a computer equipment cabinet containing a plurality of computing units, with each computing unit having at least one unit heat exchanger. In at least one embodiment, the cabinet heat exchanger can include an outer tube which can be vertically aligned within the cabinet, a plurality of inner tubes, a top port fluidically coupled to a top of the outer tube, a bottom port fluidically coupled to a bottom of the outer tube, a plurality of inlet ports spaced between the top port and the bottom port, an outlet port which can be fluidically coupled to a pump for circulating the first cooling fluid through the unit heat exchangers and the cabinet heat exchanger, an expansion port which can be fluidically coupled to a receiver for the first cooling fluid, or any combination thereof. In at least one embodiment, the inner tubes can be disposed at least partially within and/or parallel to the outer tube. In at least one embodiment, the inlet ports can be spaced between the top port and the bottom port. In at least one embodiment, each inlet port can receive a first cooling fluid from a different one of the unit heat exchangers. In at least one embodiment, the outlet port can be adjacent to the bottom port and/or the expansion port can be adjacent to the top port. In at least one embodiment, the inner tubes can physically isolate the first cooling fluid from a second cooling fluid which can flow between the top port and the bottom port. In at least one embodiment, the second cooling fluid can flow within the inner tubes and the first cooling fluid can flow within the outer tube and outside of the inner tubes.

### BRIEF DESCRIPTION OF THE DRAWINGS

FIG. 1 is a schematic view of one of many embodiments of a cooling system for a data center according to the disclosure.
FIG. 2 is a schematic view of another one of many embodiments of a cooling system for a data center according to the disclosure.
FIG. 3 is a sectional view of one of many embodiments of a heat exchanger for use in a cooling system for a data center according to the disclosure.
FIG. 4 is a sectional view of another one of many embodiments of a heat exchanger for use in a cooling system for a data center according to the disclosure.
FIG. 5 is a perspective view of a portion of one of many embodiments of a heat exchanger for use in a cooling system for a data center according to the disclosure.
FIG. 6 is a perspective view of another portion of the heat exchanger of FIG. 5.
FIG. 7 is a perspective view of yet another portion of the heat exchanger of FIG. 5.
FIG. 8 is a perspective view of still another portion of the heat exchanger of FIG. 5.
FIG. 9 is a simplified diagram of another one of many embodiments of a heat exchanger for use in a cooling system for a data center according to the disclosure.
FIG. 10 is a simplified diagram of a portion of one of many embodiments of a cooling system for a data center according to the disclosure.

### DETAILED DESCRIPTION

The figures described above and the written description of specific structures and functions below are not presented to limit the scope of what Applicant has invented or the scope of the appended claims. Rather, the figures and written description are provided to teach any person skilled in the art to make and use the inventions for which patent protection is sought. Those skilled in the art will appreciate that not all features of a commercial embodiment of the inventions are described or shown for the sake of clarity and understanding. Persons of skill in this art will also appreciate that the development of an actual commercial embodiment incorporating aspects of the present inventions will require numerous implementation-specific decisions to achieve the developer's ultimate goal for the commercial embodiment. Such implementation-specific decisions may include, and likely are not limited to, compliance with system-related, business-related, government-related and other constraints, which may vary by specific implementation, location and from time to time. While a developer's efforts might be complex and time-consuming in an absolute sense, such efforts would be, nevertheless, a routine undertaking for those of skill in this art having benefit of this disclosure. It must be understood that the inventions disclosed and taught herein are susceptible to numerous and various modifications and alternative forms.

The use of a singular term, such as, but not limited to, "a," is not intended as limiting of the number of items. Also, the use of relational terms, such as, but not limited to, "top," "bottom," "left," "right," "upper," "lower," "down," "up," "side," and the like are used in the written description for clarity in specific reference to the figures and are not intended to limit the scope of the inventions or the appended claims. The terms "including" and "such as" are illustrative and not limitative. The terms "couple," "coupled," "coupling," "coupler," and like terms are used broadly herein and can include any method or device for securing, binding, bonding, fastening, attaching, joining, inserting therein, forming thereon or therein, communicating, or otherwise associating, for example, mechanically, magnetically, electrically, chemically, operably, directly or indirectly with intermediate elements, one or more pieces of members together and can further include without limitation integrally forming one functional member with another in a unity fashion. The coupling can occur in any direction, including rotationally. Further, all parts and components of the disclosure that are capable of being physically embodied inherently include imaginary and real characteristics regardless of whether such characteristics are expressly described herein, including but not limited to characteristics such as axes, ends, inner and outer surfaces, interior spaces, tops, bottoms, sides, boundaries, dimensions (e.g., height, length, width, thickness), mass, weight, volume and density, among others.

Applicant has created new and useful devices, systems and methods for heat exchangers used in cooling systems for data centers. By locating a heat exchanger in each computer equipment cabinet, such as in existing dead space, the use of valuable real estate can be maximized and system redundancy can be achieved. Embodiments of the disclosure can provide several unique advantages. For example, by locating a heat exchanger in each computer equipment cabinet, the overall amount of refrigerant required can be reduced and relatively long plumbing lines can be eliminated.

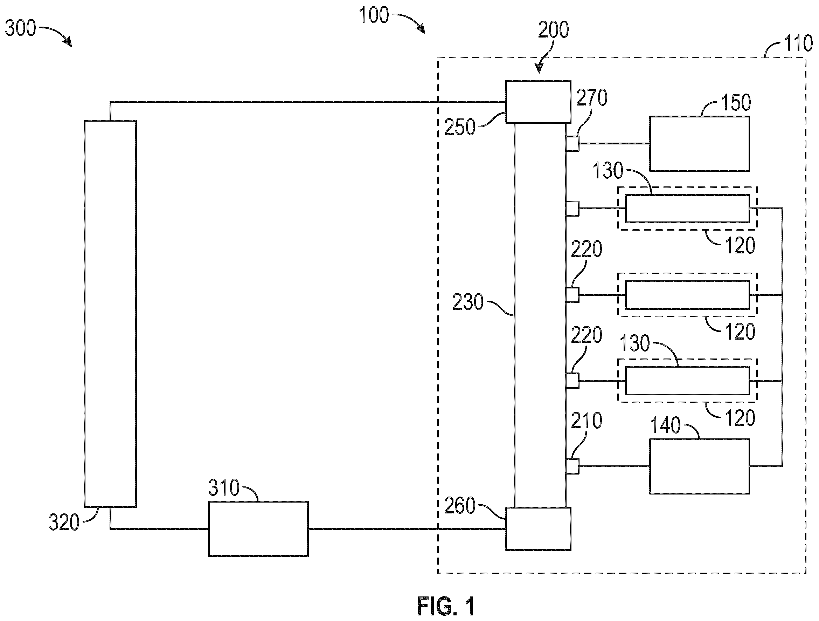

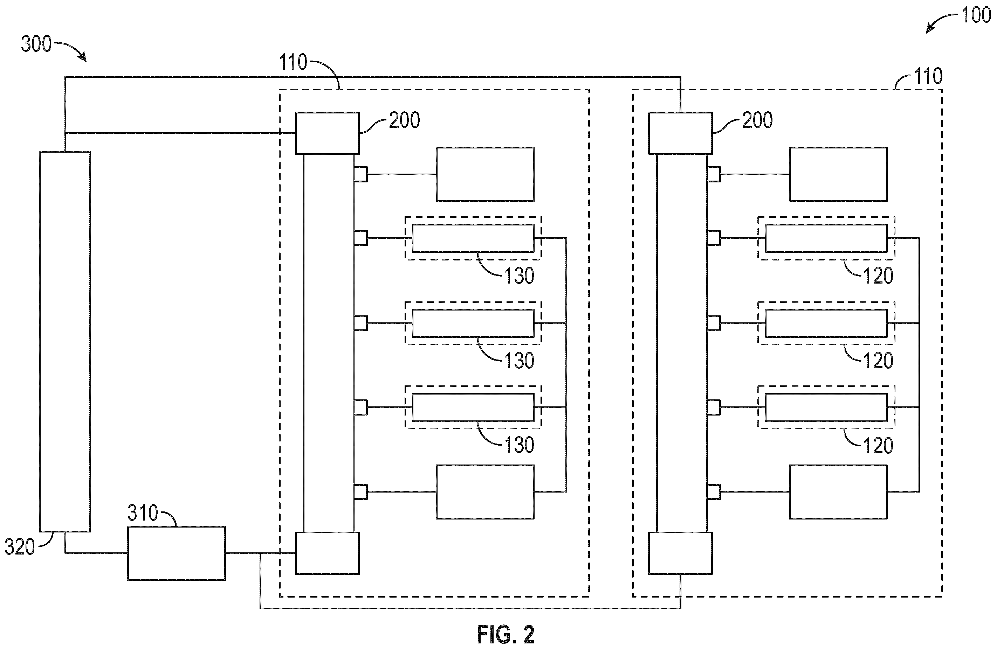

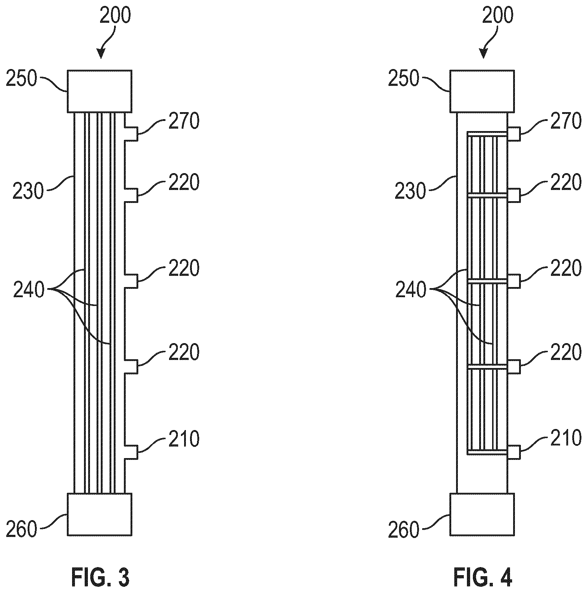

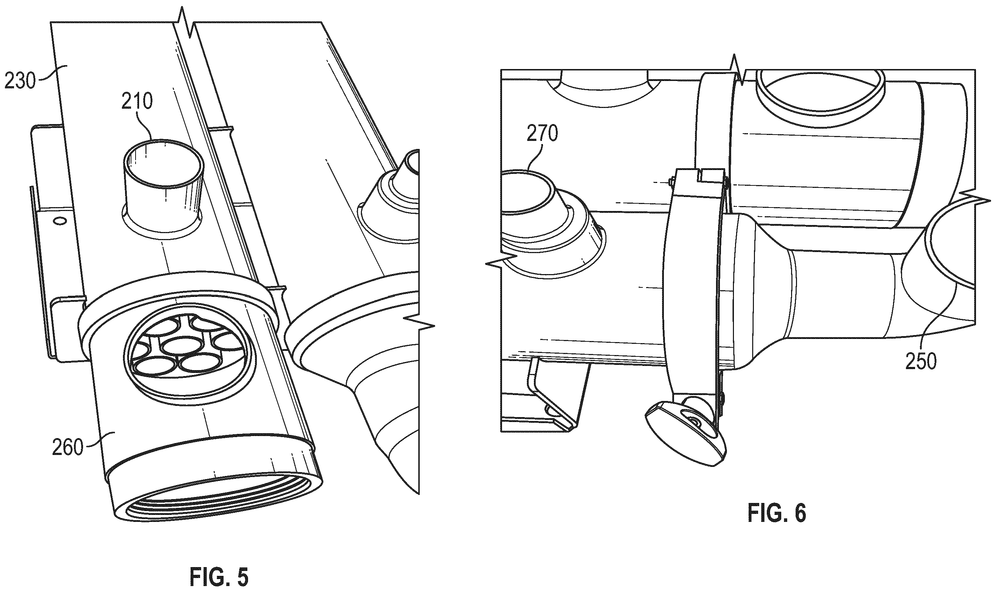

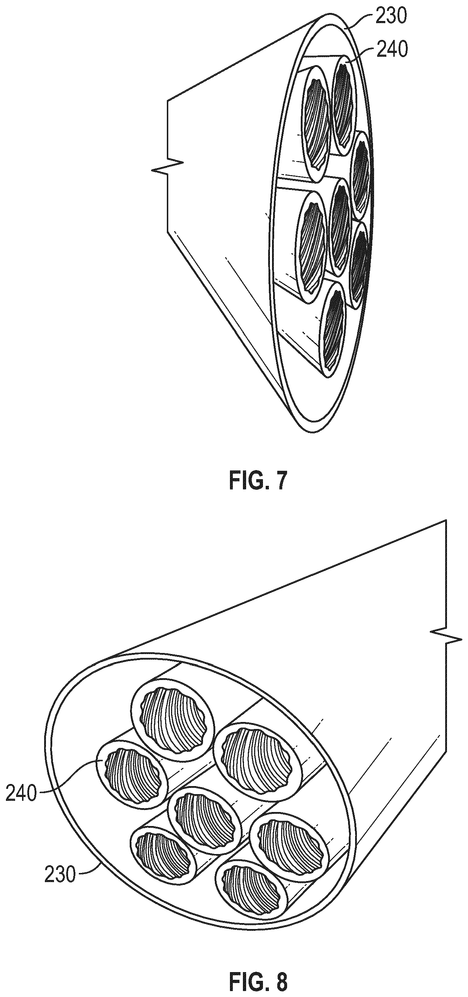

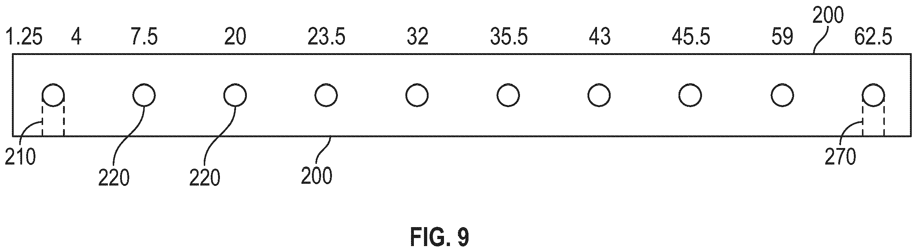

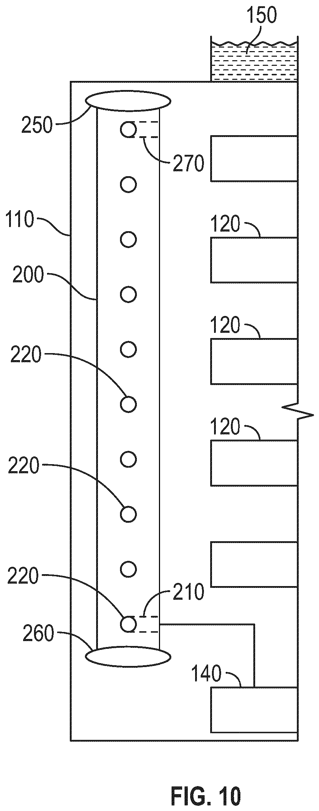

FIG. 1 is a schematic view of one of many embodiments of a cooling system for a data center according to the disclosure. FIG. 2 is a schematic view of another one of many embodiments of a cooling system for a data center according to the disclosure. FIG. 3 is a sectional view of one of many embodiments of a heat exchanger for use in a cooling system for a data center according to the disclosure. FIG. 4 is a sectional view of another one of many embodiments of a heat exchanger for use in a cooling system for a data center according to the disclosure. FIG. 5 is a perspective view of a portion of one of many embodiments of a heat exchanger for use in a cooling system for a data center according to the disclosure. FIG. 6 is a perspective view of another portion of the heat exchanger of FIG. 5. FIG. 7 is a perspective view of yet another portion of the heat exchanger of FIG. 5. FIG. 8 is a perspective view of still another portion of the heat exchanger of FIG. 5. FIG. 9 is a simplified diagram of another one of many embodiments of a heat exchanger for use in a cooling system for a data center according to the disclosure. FIG. 10 is a simplified diagram of a portion of one of many embodiments of a cooling system for a data center according to the disclosure. FIGS. 1-10 are described in conjunction with one another.

In at least one embodiment, a system 100 according to the disclosure can include a computer equipment cabinet 110 which can contain one or more computing units 120 and/or a cabinet heat exchanger 200 disposed at least partially in the cabinet 100 for cooling the one or more computing units 120. In at least one embodiment, each computing unit 120 can comprise one or more servers, network routers, other computing devices, or any combination thereof. In at least one embodiment, each computing unit 120 can include one or more unit heat exchangers 130, such as a cold plate thermally coupled to a processor. In at least one embodiment, the cabinet heat exchanger 200 can receive a first cooling fluid from each of the unit heat exchangers 130 and/or transfer heat from the first cooling fluid to a second cooling fluid. In at least one embodiment, the cabinet heat exchanger 200 can have one or more outlet ports 210 fluidically coupled to one or more pumps and/or compressors 140 for circulating the first cooling fluid through the unit heat exchangers 130 and the cabinet heat exchanger 200.

In at least one embodiment, the cabinet heat exchanger 200 can be fluidically coupled to an external cooling circuit 300 for removing the heat from the second cooling fluid. For example, an external pump or compressor 310 can circulate the second cooling fluid through the cabinet heat exchanger 200 and one or more external heat exchangers 320. In at least one embodiment, the external pump 310 can circulate the second cooling fluid through multiple cabinet heat exchangers 200 and one or more external heat exchangers 320. In at least one embodiment, either of the cooling fluids can be a refrigerant or a water-glycol mixture. In at least one embodiment, the first cooling fluid can be a refrigerant and the second cooling fluid can be a water-glycol mixture.

In at least one embodiment, the cabinet heat exchanger 200 can fit within the cabinet 110, such as within what would otherwise have been dead space within the cabinet 110. For example, in at least one embodiment, the cabinet heat exchanger 200 can fit within the cabinet 110, alongside the computing units 120 in the space between the computing units 120 and a wall of the cabinet 110.

In at least one embodiment, the cabinet heat exchanger 200 can receive the first cooling fluid from each of the plurality of computing units 120 through one or more distinct inlet ports 220 in fluid communication with a corresponding computing unit 120. For example, the cabinet heat exchanger 200 can have a plurality of inlet ports 220 for receiving the first cooling fluid from the unit heat exchangers 130, one or more distinct inlet ports 220 for each of the plurality of computing units 120, one or more distinct inlet ports 220 for each of the unit heat exchangers 130, or any combination thereof. In at least one embodiment, the inlet ports 220 can be vertically aligned and/or evenly spaced with one another. In at least one embodiment, the inlet ports 220 can be vertically offset and/or unevenly spaced with one another. For example, one or more inlet ports 220 can be rotated about the cabinet heat exchanger 200 by 45, 60, or 90 degrees with respect to another inlet port 220 and/or the outlet port 210. In at least one embodiment, the inlet ports 220 can be located along the cabinet heat exchanger 200 adjacent to fluid ports or connections of the unit heat exchangers 130.

In at least one embodiment, the cabinet heat exchanger 200 can include one or more outer tubes 230 and/or a plurality of inner tubes 240. In at least one embodiment, any or all of the tubes 230, 240 can be cylindrical. In at least one embodiment, any or all of the tubes 230, 240 can have a circular, oval, square, rectangular, or other cross- sectional shape. In at least one embodiment, each inner tube 240 can be disposed at least partially within and/or parallel to (i.e., at least substantially parallel to) the outer tube 230. In at least one embodiment, the inner tubes 240 can physically isolate the first cooling fluid from the second cooling fluid. In at least one embodiment, the first cooling fluid can flow within the inner tubes 240 and the second cooling fluid can flow within the outer tube 230 and outside of the inner tubes 230. In at least one embodiment, the second cooling fluid can flow within the inner tubes 240 and the first cooling fluid can flow within the outer tube 230 and outside of the inner tubes 240.

In at least one embodiment, the cabinet heat exchanger 200 can be vertically aligned (i.e., at least substantially vertically oriented). In at least one embodiment, the cabinet heat exchanger 200 can have one or more top ports 250 and/or one or more bottom ports 260 through which the second cooling fluid flows. In at least one embodiment, the cabinet heat exchanger 200 can have a plurality of inlet ports 220 spaced between the top port 250 and the bottom port 260. In at least one embodiment, each inlet port 220 can receive the first cooling fluid from a different one of the unit heat exchangers 130. In at least one embodiment, the cabinet heat exchanger 200 can have one or more outlet ports 210, such as adjacent to the bottom port 260, which can be fluidically coupled to one or more pumps 140 for circulating the first cooling fluid through the unit heat exchangers 130 and the cabinet heat exchanger 200. In at least one embodiment, the cabinet heat exchanger 200 can have one or more expansion ports 270, such as adjacent to the top port 250, which can be fluidically coupled to one or more receivers 150 for the first cooling fluid.

In at least one embodiment, the cabinet heat exchanger 200 can have a plurality of inlet ports 220. In at least one embodiment, each inlet port 220 can receive the first cooling fluid from a different one of the unit heat exchangers 130. In at least one embodiment, each inlet port 220 can be fluidically coupled to an interior of the outer tube 230 and fluidically isolated from an interior of the inner tubes 240. In at least one embodiment, each inlet port 220 can be fluidically coupled to an interior of at least one of the inner tubes 240.

In at least one embodiment, the pump 140 and/or the receiver 150 can be smaller than those used in other cooling systems, such as those serving an entire data center. In at least one embodiment, the pump 140 and/or the receiver 150 can be coupled to and/or disposed at least partially within the cabinet 110. In at least one embodiment, the pump 140 and/or the receiver 150 can be coupled to but outside the cabinet 110. In at least one embodiment, the pump 140 and/or the receiver 150 can be disposed at least partially apart from the cabinet 110. In at least one embodiment, the pump 140 and/or the receiver 150 can serve one or more cabinet heat exchangers 200 and/or cabinets 110. In at least one embodiment, each cabinet heat exchanger 200 and/or cabinet 110 can have their own pump 140 and/or receiver 150. In at least one embodiment, multiple pumps 140, multiple receivers 150, multiple cabinet heat exchangers 200, or any combination thereof can be coupled to and/or disposed at least partially within the cabinet 110.

In at least one embodiment, the external pump 310 and/or the external heat exchanger 320 can be disposed at least partially apart from the cabinet 110 within or outside the data center. In at least one embodiment, the external pump 310 and/or the external heat exchanger 320 can be coupled to but outside the cabinet 110. In at least one embodiment, the external pump 310 and/or the external heat exchanger 320 can be disposed at least partially within a separate compartment of the cabinet 110. In at least one embodiment, the external pump 310 and/or the external heat exchanger 320 can serve multiple cabinet heat exchangers 200 and/or cabinets 110.

In at least one embodiment, a cabinet heat exchanger 200 according to the disclosure can be disposed at least partially within a computer equipment cabinet 110 containing one or more computing units 120, with each computing unit 120 having one or more unit heat exchanger 130. In at least one embodiment, the cabinet heat exchanger 200 can include one or more outer tubes 230 which can be vertically aligned within the cabinet 110, one or more inner tubes 240, one or more top ports 250 fluidically coupled to a top of the outer tube 230, one or more bottom ports fluidically coupled to a bottom of the outer tube 230, one or more inlet ports 220 spaced between the top port 250 and the bottom port 260, one or more outlet port 210 which can be fluidically coupled to one or more pumps 140 for circulating the first cooling fluid through the unit heat exchangers 130 and the cabinet heat exchanger 200, one or more expansion ports 270 which can be fluidically coupled to one or more receivers 150 for the first cooling fluid, or any combination thereof. In at least one embodiment, the inner tubes 240 can be disposed at least partially within and/or parallel to the outer tube 230. In at least one embodiment, the inlet ports 220 can be spaced between the top port 250 and the bottom port 260. In at least one embodiment, each inlet port 220 can receive a first cooling fluid from a different one of the unit heat exchangers 130. In at least one embodiment, the outlet port 210 can be adjacent to the bottom port 260 and/or the expansion port 270 can be adjacent to the top port 250. In at least one embodiment, the inner tubes 240 can physically isolate the first cooling fluid from a second cooling fluid which can flow between the top port 250 and the bottom port 260. In at least one embodiment, the second cooling fluid can flow within the inner tubes 240 and the first cooling fluid can flow within the outer tube 230 and outside of the inner tubes 230.

In at least one embodiment, a system according to the disclosure can include a computer equipment cabinet for containing a plurality of computing units and/or a cabinet heat exchanger disposed at least partially in the cabinet. In at least one embodiment, each computing unit can include at least one unit heat exchanger, such as a cold plate thermally coupled to a processor. In at least one embodiment, the cabinet heat exchanger can receive a first cooling fluid from each of the unit heat exchangers and/or transfer heat from the first cooling fluid to a second cooling fluid. In at least one embodiment, the cabinet heat exchanger can have an outlet port fluidically coupled to a pump for circulating the first cooling fluid through the unit heat exchangers and the cabinet heat exchanger. In at least one embodiment, the cabinet heat exchanger can be fluidically coupled to an external cooling circuit for removing the heat from the second cooling fluid.

In at least one embodiment, the cabinet heat exchanger can receive the first cooling fluid from each of the plurality of computing units through a distinct inlet port. For example, the cabinet heat exchanger can have a plurality of inlet ports for receiving the first cooling fluid from the unit heat exchangers, a distinct inlet port for each of the plurality of computing units, a distinct inlet port for each of the unit heat exchangers, or any combination thereof.

In at least one embodiment, the cabinet heat exchanger can include an outer tube and/or a plurality of inner tubes. In at least one embodiment, each inner tube can be disposed at least partially within and/or parallel to the outer tube. In at least one embodiment, the inner tubes can physically isolate the first cooling fluid from the second cooling fluid. In at least one embodiment, the first cooling fluid can flow within the inner tubes and the second cooling fluid can flow within the outer tube and outside of the inner tubes. In at least one embodiment, the second cooling fluid can flow within the inner tubes and the first cooling fluid can flow within the outer tube and outside of the inner tubes.

In at least one embodiment, the cabinet heat exchanger can be vertically aligned. In at least one embodiment, the cabinet heat exchanger can have a top port and/or a bottom port through which the second cooling fluid flows. In at least one embodiment, the cabinet heat exchanger can have a plurality of inlet ports spaced between the top port and the bottom port. In at least one embodiment, each inlet port can receive the first cooling fluid from a different one of the unit heat exchangers. In at least one embodiment, the cabinet heat exchanger can have an outlet port, such as adjacent to the bottom port, which can be fluidically coupled to a pump for circulating the first cooling fluid through the unit heat exchangers and the cabinet heat exchanger. In at least one embodiment, the cabinet heat exchanger can have an expansion port, such as adjacent to the top port, which can be fluidically coupled to a receiver for the first cooling fluid.

In at least one embodiment, the cabinet heat exchanger can have a plurality of inlet ports. In at least one embodiment, each inlet port can receive the first cooling fluid from a different one of the unit heat exchangers. In at least one embodiment, each inlet port can be fluidically coupled to an interior of the outer tube and fluidically isolated from an interior of the inner tubes. In at least one embodiment, each inlet port can be fluidically coupled to an interior of at least one of the inner tubes.

In at least one embodiment, a cabinet heat exchanger according to the disclosure can be disposed at least partially within a computer equipment cabinet containing a plurality of computing units, with each computing unit having at least one unit heat exchanger. In at least one embodiment, the cabinet heat exchanger can include an outer tube which can be vertically aligned within the cabinet, a plurality of inner tubes, a top port fluidically coupled to a top of the outer tube, a bottom port fluidically coupled to a bottom of the outer tube, a plurality of inlet ports spaced between the top port and the bottom port, an outlet port which can be fluidically coupled to a pump for circulating the first cooling fluid through the unit heat exchangers and the cabinet heat exchanger, an expansion port which can be fluidically coupled to a receiver for the first cooling fluid, or any combination thereof. In at least one embodiment, the inner tubes can be disposed at least partially within and/or parallel to the outer tube. In at least one embodiment, the inlet ports can be spaced between the top port and the bottom port. In at least one embodiment, each inlet port can receive a first cooling fluid from a different one of the unit heat exchangers. In at least one embodiment, the outlet port can be adjacent to the bottom port and/or the expansion port can be adjacent to the top port. In at least one embodiment, the inner tubes can physically isolate the first cooling fluid from a second cooling fluid which can flow between the top port and the bottom port. In at least one embodiment, the second cooling fluid can flow within the inner tubes and the first cooling fluid can flow within the outer tube and outside of the inner tubes.

Other and further embodiments utilizing one or more aspects of the disclosure can be devised without departing from the spirit of Applicant's disclosure. For example, the devices, systems and methods can be implemented for numerous different types and sizes in numerous different industries. Further, the various methods and embodiments of the devices, systems and methods can be included in combination with each other to produce variations of the disclosed methods and embodiments. Discussion of singular elements can include plural elements and vice versa. The order of steps can occur in a variety of sequences unless otherwise specifically limited. The various steps described herein can be combined with other steps, interlineated with the stated steps, and/or split into multiple steps. Similarly, elements have been described functionally and can be embodied as separate components or can be combined into components having multiple functions.

Further examples are set out in the clauses below:
1. A system comprising:
   a computer equipment cabinet configured to contain a plurality of computing units, each computing unit having at least one unit heat exchanger; and
   a cabinet heat exchanger disposed at least partially in the cabinet and configured to:
      receive a first cooling fluid from each of the unit heat exchangers, and
      transfer heat from the first cooling fluid to a second cooling fluid.
2. The system as set forth in clause 1, wherein the cabinet heat exchanger includes a plurality of inlet ports configured to receive the first cooling fluid from the unit heat exchangers.
3. The system as set forth in clause 1 or 2, wherein the cabinet heat exchanger includes a distinct inlet port for each of the plurality of computing units.
4. The system as set forth in any one of the preceding clauses, wherein the cabinet heat exchanger includes a distinct inlet port for each of the unit heat exchangers.
5. The system as set forth in any one of the preceding clauses, wherein the cabinet heat exchanger is configured to receive the first cooling fluid from each of the plurality of computing units through a distinct inlet port.
6. The system as set forth in any one of the preceding clauses, wherein the cabinet heat exchanger includes an outlet port fluidically coupled to a pump configured to circulate the first cooling fluid through the unit heat exchangers and the cabinet heat exchanger.
7. The system as set forth in clause 1, wherein the cabinet heat exchanger comprises:
   an outer tube; and
   a plurality of inner tubes;

   wherein each inner tube is disposed at least partially within and parallel to the outer tube, and
   wherein the inner tubes are configured to isolate the first cooling fluid from the second cooling fluid.
8. The system as set forth in clause 7, wherein the cabinet heat exchanger is vertically aligned.
9. The system as set forth in clause 8, wherein the cabinet heat exchanger includes a top port and a bottom port through which the second cooling fluid flows.
10. The system as set forth in clause 9, wherein the cabinet heat exchanger includes a plurality of inlet ports spaced between the top port and the bottom port, and wherein each inlet port is configured to receive the first cooling fluid from a different one of the unit heat exchangers.
11. The system as set forth in clause 9, wherein the cabinet heat exchanger includes an outlet port adjacent to the bottom port and fluidically coupled to a pump configured to circulate the first cooling fluid through the unit heat exchangers and the cabinet heat exchanger.
12. The system as set forth in clause 9, wherein the cabinet heat exchanger includes an expansion port adjacent to the top port and fluidically coupled to a receiver for the first cooling fluid.
13. The system as set forth in clause 7, wherein the first cooling fluid flows within the inner tubes and the second cooling fluid flows within the outer tube and outside of the inner tubes.
14. The system as set forth in clause 7, wherein the second cooling fluid flows within the inner tubes and the first cooling fluid flows within the outer tube and outside of the inner tubes.
15. The system as set forth in clause 7, wherein the cabinet heat exchanger includes a plurality of inlet ports, and wherein each inlet port is configured to receive the first cooling fluid from a different one of the unit heat exchangers.
16. The system as set forth in clause 15, wherein each inlet port is fluidically coupled to an interior of the outer tube and fluidically isolated from an interior of the inner tubes.
17. he system as set forth in clause 15, wherein each inlet port is fluidically coupled to an interior of at least one of the inner tubes.
18. A cabinet heat exchanger configured to be disposed at least partially within a computer equipment cabinet containing a plurality of computing units, each computing unit having at least one unit heat exchanger, the cabinet heat exchanger comprising:
   an outer tube configured to be vertically aligned within the cabinet;
   a plurality of inner tubes, wherein each inner tube is disposed at least partially within and parallel to the outer tube;
   a top port fluidically coupled to a top of the outer tube;
   a bottom port fluidically coupled to a bottom of the outer tube;
   a plurality of inlet ports spaced between the top port and the bottom port, wherein each inlet port is configured to receive a first cooling fluid from a different one of the unit heat exchangers; and
   an outlet port adjacent to the bottom port and configured to be fluidically coupled to a pump to circulate the first cooling fluid through the unit heat exchangers and the cabinet heat exchanger,
   wherein the inner tubes are configured to isolate the first cooling fluid from a second cooling fluid flowing between the top port and the bottom port.
19. The cabinet heat exchanger as set forth in clause 18, wherein the second cooling fluid flows within the inner tubes and the first cooling fluid flows within the outer tube and outside of the inner tubes.
20. The cabinet heat exchanger as set forth in clause 18, wherein the cabinet heat exchanger includes an expansion port adjacent to the top port and fluidically coupled to a receiver for the first cooling fluid.
21. A method as shown and/or described herein.
22. A system as shown and/or described herein.
23. A device as shown and/or described herein.
24. The inventions have been described in the context of preferred and other embodiments and not every embodiment of the inventions has been described. Obvious modifications and alterations to the described embodiments are available to those of ordinary skill in the art having the benefits of the present disclosure. The disclosed and undisclosed embodiments are not intended to limit or restrict the scope or applicability of the inventions conceived of by the Applicant, but rather, in conformity with the patent laws, Applicant intends to fully protect all such modifications and improvements that come within the scope or range of equivalents of the following claims.

## Claims

1. A system comprising:
a computer equipment cabinet configured to contain a plurality of computing units, each computing unit having at least one unit heat exchanger; and
a cabinet heat exchanger disposed at least partially in the cabinet and configured to:
receive a first cooling fluid from each of the unit heat exchangers; and
transfer heat from the first cooling fluid to a second cooling fluid.

2. The system as set forth in claim 1, wherein the cabinet heat exchanger includes a plurality of inlet ports configured to receive the first cooling fluid from the unit heat exchangers.

3. The system as set forth in claim 1, wherein the cabinet heat exchanger includes a distinct inlet port for each of the plurality of computing units.

4. The system as set forth in claim 1, wherein the cabinet heat exchanger includes a distinct inlet port for each of the unit heat exchangers.

5. The system as set forth in claim 1, wherein the cabinet heat exchanger is configured to receive the first cooling fluid from each of the plurality of computing units through a distinct inlet port.

6. The system as set forth in claim 1, wherein the cabinet heat exchanger includes an outlet port fluidically coupled to a pump configured to circulate the first cooling fluid through the unit heat exchangers and the cabinet heat exchanger.

7. The system as set forth in claim 1, wherein the cabinet heat exchanger comprises:
an outer tube; and
a plurality of inner tubes;
wherein each inner tube is disposed at least partially within and parallel to the outer tube; and
wherein the inner tubes are configured to isolate the first cooling fluid from the second cooling fluid.

8. The system as set forth in claim 7, wherein the cabinet heat exchanger is vertically aligned.

9. The system as set forth in claim 8, wherein the cabinet heat exchanger includes a top port and a bottom port through which the second cooling fluid flows.

10. The system as set forth in claim 9, wherein the cabinet heat exchanger includes a plurality of inlet ports spaced between the top port and the bottom port, and wherein each inlet port is configured to receive the first cooling fluid from a different one of the unit heat exchangers.

11. The system as set forth in claim 9, wherein the cabinet heat exchanger includes an outlet port adjacent to the bottom port and fluidically coupled to a pump configured to circulate the first cooling fluid through the unit heat exchangers and the cabinet heat exchanger.

12. The system as set forth in claim 9, wherein the cabinet heat exchanger includes an expansion port adjacent to the top port and fluidically coupled to a receiver for the first cooling fluid.

13. The system as set forth in claim 7, wherein the first cooling fluid flows within the inner tubes and the second cooling fluid flows within the outer tube and outside of the inner tubes.

14. The system as set forth in claim 7, wherein the second cooling fluid flows within the inner tubes and the first cooling fluid flows within the outer tube and outside of the inner tubes.

15. The system as set forth in claim 7, wherein the cabinet heat exchanger includes a plurality of inlet ports, and wherein each inlet port is configured to receive the first cooling fluid from a different one of the unit heat exchangers.

16. The system as set forth in claim 15, wherein each inlet port is fluidically coupled to an interior of the outer tube and fluidically isolated from an interior of the inner tubes.

17. The system as set forth in claim 15, wherein each inlet port is fluidically coupled to an interior of at least one of the inner tubes.

18. A cabinet heat exchanger configured to be disposed at least partially within a computer equipment cabinet containing a plurality of computing units, each computing unit having at least one unit heat exchanger, the cabinet heat exchanger comprising:
an outer tube configured to be vertically aligned within the cabinet;
a plurality of inner tubes, wherein each inner tube is disposed at least partially within and parallel to the outer tube;
a top port fluidically coupled to a top of the outer tube;
a bottom port fluidically coupled to a bottom of the outer tube;
a plurality of inlet ports spaced between the top port and the bottom port, wherein each inlet port is configured to receive a first cooling fluid from a different one of the unit heat exchangers; and
an outlet port adjacent to the bottom port and configured to be fluidically coupled to a pump to circulate the first cooling fluid through the unit heat exchangers and the cabinet heat exchanger;
wherein the inner tubes are configured to isolate the first cooling fluid from a second cooling fluid flowing between the top port and the bottom port.

19. The cabinet heat exchanger as set forth in claim 18, wherein the second cooling fluid flows within the inner tubes and the first cooling fluid flows within the outer tube and outside of the inner tubes.

20. The cabinet heat exchanger as set forth in claim 18, wherein the cabinet heat exchanger includes an expansion port adjacent to the top port and fluidically coupled to a receiver for the first cooling fluid.
